## Europäisches Patentamt
## European Patent Office
## Office européen des brevets

(19)

(11) Numéro de publication: **0 091 859**
**B1**

(12) # FASCICULE DE BREVET EUROPÉEN

(45) Date de publication du fascicule du brevet:
**31.05.89**

(51) Int. Cl.⁴: **H 01 S 3/23**

(21) Numéro de dépôt: **83400673.6**

(22) Date de dépôt: **31.03.83**

(54) **Procédé de réalisation d'un laser à semi-conducteur à plusieurs longueurs d'onde indépendantes.**

(30) Priorité: **08.04.82 FR 8206179**

(43) Date de publication de la demande:
**19.10.83 Bulletin 83/42**

(45) Mention de la délivrance du brevet:
**31.05.89 Bulletin 89/22**

(84) Etats contractants désignés:
**DE GB NL**

(56) Documents cité:
**EP-A-0 061 220**
**US-A-4 293 826**
**US-A-4 318 058**

**PATENTS ABSTRACTS OF JAPAN, vol. 3, no. 131 (E-148), 31 octobre 1979, page 9 E 148; & JP - A - 54 107 689 (NIPPON DENKI K.K.) 23-08-1979**
**ELECTRONICS, vol. 55, no. 22, 3 novembre 1982, pages 72-73, New York, US; R. GALLAGHER: "Integrating two multiplexed optical sources allows direct coupling to single fiber"**

(73) Titulaire: **Bouadma, Noureddine, 45 A. Boulevard Jourdan, F-75014 Paris (FR)**
Titulaire: **Bouley, Jean- Claude, 35, Avenue du Docteur Durand, F-94110 Arcueil (FR)**
Titulaire: **Riou, Jean, 25, Avenue de la Division Leclerc, F-94230 Cachan (FR)**

(72) Inventeur: **Bouadma, Noureddine, 45 A. Boulevard Jourdan, F-75014 Paris (FR)**
Inventeur: **Bouley, Jean- Claude, 35, Avenue du Docteur Durand, F-94110 Arcueil (FR)**
Inventeur: **Riou, Jean, 25, Avenue de la Division Leclerc, F-94230 Cachan (FR)**

(74) Mandataire: **Mongrédien, André, c/o BREVATOME 25, rue de Ponthieu, F-75008 Paris (FR)**

## Description

La présente invention a pour objet un procédé de réalisation d'un laser à semi-conducteur à plusieurs longueurs d'onde indépendantes et un laser obtenu par ce procédé. Elle trouve une application en télécommunications optiques.

Le domaine technique de l'invention est celui des lasers à semi-conducteurs dits à double hétérostructure et à jonction en forme de ruban. Une double hétérostructure est constituée d'un empilement de couches semiconductrices déposées sur un substrat monocristallin. On trouve en général, en partant du substrat, une couche de confinement, une couche active, une seconde couche de confinement, et une couche de contact recouverte d'une couche métallique.

Pour les lasers émettant entre 0,8 et 0,9 µm, ces couches sont en alliage $Ga_{1-x}Al_xAs$ et le substrat en GaAs; pour les lasers émettant entre 1,3 et 1,65 µm, les couches sont en $Ga_{1-x}In_xAs_{1-y}P_y$ et le substrat est en InP.

Le fonctionnement en continu de ces lasers est obtenu en réduisant la partie active à un ruban d'une dizaine de microns de large et de 300 microns de long. Ce ruban est obtenu par bombardement protonique de part et d'autre de la zone devant rester active.

Le domaine privilégié des lasers à semiconducteurs est celui des systèmes de télécommunications par fibres optiques. Dans le but d'augmenter la capacité de transmission de ces systèmes, il est fait usage, le plus souvent, d'un multiplexage en longueur d'onde. La solution généralement retenue consiste à raccorder des lasers émettant à différentes longueurs d'onde à une fibre optique unique, par l'intermédiaire d'un multiplexeur optique.

Le but de l'invention est un procédé de réalisation d'un laser capable d'émettre, à lui seul, plusieurs longueurs d'onde de sorte qu'un tel laser puisse être couplé à une même fibre optique sans multiplexeur.

Le brevet américain 4 318 058 décrit, notamment par sa figure 4 un dispositif comprenant plusieurs lasers séparés par des sillons. Ces lasers ont en commun un substrat, une couche de confinement, et une couche active en $Al_xGa_{1-x}As$ dans laquelle la proportion x n'est pas la même pour les différents lasers.

Ce brevet décrit en outre un procédé de fabrication d'un tel dispositif. Pour obtenir une couche active de composition variée, on utilise un dispositif comprenant un masque percé d'une fente, à travers laquelle on effectue une épitaxie moléculaire. On obtient ainsi une couche active dont le pourcentage x peut être par exemple continuement croissant.

Le but de l'invention est de fournir un autre procédé de réalisation d'un laser à plusieurs longueurs d'onde, plus simple que le procédé antérieur. Ce procédé est destiné à obtenir un laser à semiconducteur à plusieurs longueurs d'onde du type à double hétérostructure et à ruban, la double hétérostructure étant formée d'un substrat muni d'un contact électrique, d'une première couche de confinement déposée sur le substrat, d'une couche active recouvrant la couche de confinement, d'une seconde couche de confinement recouvrant la couche active et d'une couche de contact recouverte d'une couche métallique surmontant le tout, le ruban étant défini par deux zones latérales ayant subi un bombardement protonique et s'étendant à travers la couche de contact et une partie de la couche de confinement la couche active présente dans son plan au moins deux zones de compositions différentes, chaque zone définissant un laser émettant à une longueur d'onde définie par la composition de cette zone, les différents lasers ainsi définis étant isolés électriquement les uns des autres par des sillons gravés dans la couche de contact et la couche de confinement et affleurant la couche active, chaque laser possédant ainsi une couche de contact en propre mais un substrat en commun avec les autres lasers, les différents lasers étant isolés optiquement les uns des autres par la zone de la couche active située sous le sillon, zone qui a subi le bombardement protonique définissant chaque ruban.

A cette fin, le procédé de l'invention est caractérisé en ce que:

- on réalise une première double hétérostructure par épitaxie avec une couche active ayant une première composition,
- on décape la double première hétérostructure obtenue, jusque dans le substrat, à travers un masque muni d'ouvertures en forme de bandes, ce qui conduit à un substrat sur lequel subsistent des bandes de la première double hétérostructure séparées par des parties décapées,
- on fait croître dans les parties décapées une seconde double hétérostructure avec une couche active ayant une seconde composition,
- on grave un sillon entre la première et la seconde hétérostructures jusqu'à la couche de contact,
- on effectue un bombardement protonique du sillon.

Les caractéristiques de l'invention apparaîtront mieux après la description qui suit, d'exemples de réalisation donnés à titre explicatif et nullement limitatif. Cette description se réfère à des dessins annexés sur lesquels:

- la figure 1 représente un laser à plusieurs longueurs d'onde,
- la figure 2 représente un laser associé à des photodiodes de contre-réaction selon l'invention,
- la figure 3 illustre l'une des premières étapes du procédé de fabrication selon l'invention,
- la figure 4 illustre une autre étape du procédé de fabrication selon l'invention,
- la figure 5 représente un détail du laser au voisinage du sillon gravé.

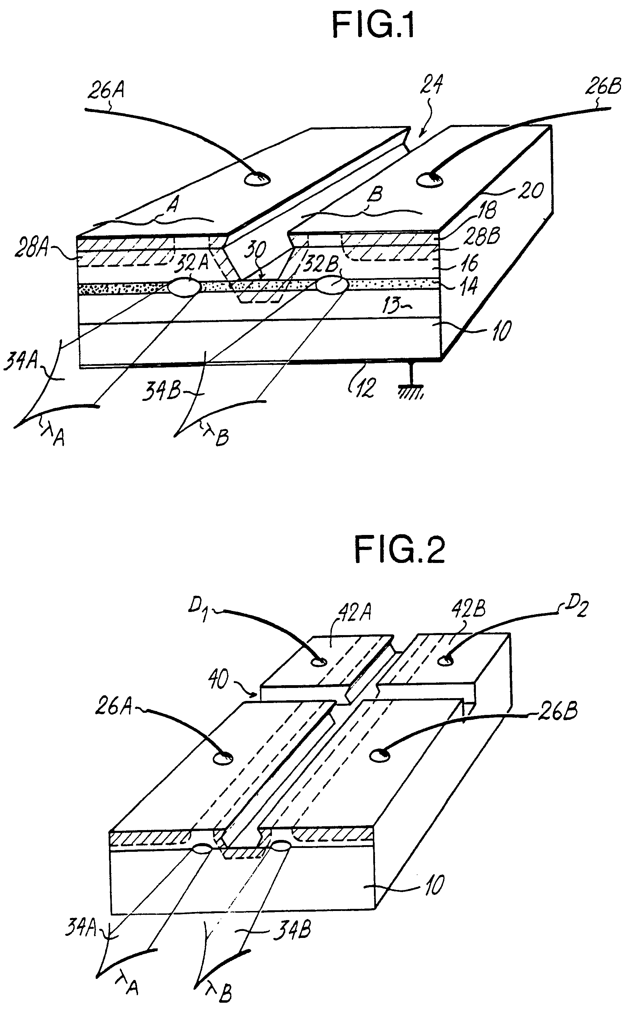

Le laser représenté sur la figure 1 comprend un substrat 10 en semiconducteur monocristallin sous lequel est déposée une couche métallique 12 reliée à la masse et sur lequel se trouvent une première couche de confinement 13, une couche active 14, une seconde couche de confinement 16, une couche de contact 18 et enfin une couche métallique 20.

La composition de la couche active 14 est différente sur la partie gauche et sur la partie droite. Il s'agit par exemple pour la partie gauche de $(Ga_{1-x}Al_xAs)$ et pour la partie droite de $(Ga_{1-y}Al_yAs)$, x et y étant inférieurs à 1 et représentant les compositions aluminium. On peut prendre par exemple x = 0 à gauche (auquel cas la couche est en GaAs) et y = 0,05 à droite (ce qui correspond à $Ga_{0,95}Al_{0,05}As$). Toute autre combinaison est naturellement possible.

Un sillon 24 est gravé dans la structure, à travers la couche métallique 20 et les couches 18 et 16 et jusqu'à la couche active 14. De cette manière sont définies deux zones d'injection de charge indépendantes, respectivement A et B. Le laser comprend donc deux connexions d'alimentation 26A et 26B mais un seul contact de masse 12.

Les rubans définissant les zones actives de chacun des lasers sont obtenus de manière classique en augmentant la résistivité des couches de confinement et de contact, par un bombardement protonique. Ce sont les zones hâchurées 28A et 28B sur la figure 1. Du fait de la présence du sillon 24, le bombardement protonique fait naître, sur les bords de ce sillon, une région isolante et notamment, dans la couche active, une zone 30, qui marque une séparation entre les deux parties de la couche active de compositions différentes.

Finalement, les deux canaux actifs 32A et 32B émettent respectivement deux rayonnements 34A, 34B aux longueurs d'onde $\lambda_A$ et $\lambda_B$ différentes et indépendantes l'une de l'autre.

A titre d'exemple, chaque ruban peut avoir une largeur de 10 µm. Le sillon gravé doit posséder une largeur minimale de 10 µm, par exemple 30 µm. L'écart entre les longueur d'onde peut être de plusieurs centaines d'Angströms (1Å = 0,1 nm). Avec des compositions de la couche active telles que GaAs et $Ga_{0,95}Al_{0,05}As$, les longueurs d'onde sont respectivement égales à 0,89 µm et 0,85 µm. Les courants de seuil des deux lasers sont 50 et 60 mA.

Les difficultés d'introduction des deux faisceaux lumineux émis par le laser de l'invention, dans une fibre multimode de 50 µm de diamètre de coeur, dépendent principalement de la distance séparant les deux faisceaux. Comme ces deux faisceaux émanent d'une structure intégrée, cette distance est très faible et de l'ordre de la largeur du sillon. Avec une distance de l'ordre de 10 µm, les pertes de couplage lors de cette introduction sont de l'ordre de 3 dB.

L'utilisation d'un tel laser dans un module d'émission complet soulève le problème du choix du photodétecteur qui est souvent associé au laser dans les dispositifs intégrés (cf. l'article de T.P. LEE et al paru dans "Electronics Letters, octobre 1980, page 845). L'utilisation de photodiodes au silicium nécessiterait l'emploi de démultiplexeurs optiques, ce qui compliquerait à nouveau le module et augmenterait son coût. Selon l'invention, on préfère intégrer ces détecteurs à la structure, comme illustré sur la figure 2, qui montre le double laser précédemment décrit avec deux photodiodes de contre-réaction.

Le laser représenté comprend un sillon 40 gravé dans les couches de contact et de confinement à proximité de l'une des extrémités de la double hétérostructure et dans une direction perpendiculaire aux deux rubans. Ce sillon est obtenu par décapage chimique ou usinage ionique. Sa largeur est de quelques dizaines de micromètres (20 typiquement). Cet usinage définit, d'une part, un des miroirs du laser (l'autre étant constitué par la face avant; qui est par exemple une face clivée) et, d'autre part, deux diodes 42A et 42B dont l'une, polarisée en inverse, peut servir de détecteur.

La quantité de lumière couplée dans le détecteur dépend de la largeur du sillon 40. Avec 20 µm, on obtient, dans le cas le plus défavorable, (mode laser à symétrie de révolution de demi-angle 20°) un coefficient de couplage de 20 dB dans le détecteur. Par ailleurs, l'absorption de la couche active à la longueur d'onde laser étant de l'ordre de 100 cm$^1$, la puissance détectée par un détecteur de 100 µm de long est de -25 dB par rapport à la puissance initiale de l'émetteur, valeur nettement suffisante pour établir une contre-réaction sur le laser.

Un exemple de procédé de réalisation de cette structure va maintenant être décrit.

La double composition de la couche active peut être obtenue en réalisant une épitaxie en deux étapes:

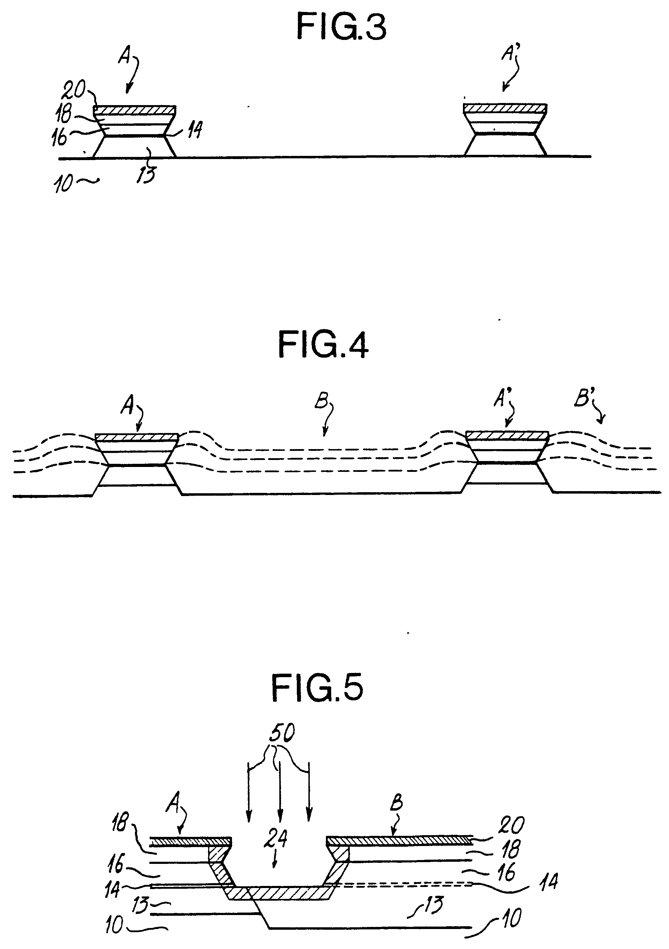

- 1ère étape:
On réalise, selon les procédés usuels, une première épitaxie qui conduit à une double hétérostructure que l'on décape par intervalle afin d'obtenir la structure illustrée sur la figure 3 qui comprend, sur le substrat 10, des bandes A, A'... séparées par des zones décapées. Ces bandes correspondent a une première composition de la couche active.

-2ème étape:
On fait croître ensuite dans les parties décapées ainsi obtenues une seconde double hétérostructure ayant une couche active différente de celle de la première. On obtient alors des zones B, B' qui remplissent les intervalles entre bandes AA'. C'est ce qui est représenté sur la figure 4. Il reste ensuite à couper le dispositif pour obtenir des couples de doubles hétérostructures AB, A'B'...

Pour l'attaque de la première double hétérostructure, on peut utiliser un masque constitué de nitrure de silicium (Si₃N₄) qui présente une bonne efficacité de masquage à 800°C et ne contamine pas les bains d'épitaxie de la seconde double hétérostructure. Les "effets de bords" après la reprise d'épitaxie sont réduits en alignant le ruban délimité dans la première double hétérostructure selon la direction <011> et en attaquant très légèrement le substrat.

Une suite possible d'opérations d'épitaxie est alors la suivante:

- réalisation de la première double hétérostructure par épitaxie liquide,
- repérage de l'orientation <011>,
- dépôt d'une couche de Si₃N₄,
- attaque de Si₃N₄ par usineur à plasma pour définir des ouvertures parallèles à la direction <011>,
- attaque chimique de la première double hétérostructure par une solution acide de H₂SO₄, H₂O₂, H₂O 1-8-1 à 2°C à travers le masque,
- décapage chimique du substrat de la première double hétérostructure par acide ammoniaqué à 60°C,
- rinçage au méthanol,
- épitaxie de la seconde double hétérostructure dans les zones décapées,
- décapage du masque de nitrure par usineur à plasma et attaque à l'acide fluoridrique.

Ces opérations effectuées, il reste à réaliser l'isolement entre les deux lasers. Pour cela, un sillon 24 est d'abord réalisé par attaque chimique à l'aide d'une solution H₂SO₄, H₂O₂, H₂O à 1-8-1, à 2°C entre les deux doubles hétérostructures A et B. La couche métallique 20 (en général du Ti-Au) des couches de contact de type p est d'abord gravée, puis sert de masque à l'attaque chimique. L'aspect du laser au voisinage du sillon est représenté en coupe sur la figure 5.

Un bombardement protonique (200 keV, $10^{15}$ cm$^{-2}$) symbolisé par les flèches 50 est ensuite effectué pour améliorer l'isolement électrique entre les deux zones de confinement et isoler optiquement les deux lasers.

Pour ce qui est de la réalisation des miroirs par attaque chimique, le masque utilisé est également le contact Ti-Au de la couche 20. La solution d'attaque est la même que précédemment.

## Revendications

1. Procédé de réalisation d'un laser à semi-conducteur à plusieurs longueurs d'onde du type à double hétérostructure et à ruban, la double hétérostructure étant formée d'un substrat (10) muni d'un contact électrique (12), d'une première couche de confinement (13) déposée sur le substrat, d'une couche active (14) recouvrant la couche de confinement, d'une seconde couche de confinement (16) recouvrant la couche active et d'une couche de contact (18) recouverte d'une couche métallique (20) surmontant le tout, le ruban étant défini par deux zones latérales (28A, 28B) ayant subi un bombardement protonique et s'étendant à travers la couche de contact et une partie de la couche de confinement, la couche active (14) présentant dans son plan au moins deux zones de compositions différentes, chaque zone définissant un laser (A, B) émettant à une longueur d'onde ($\lambda_A$, $\lambda_B$) définie par la composition de cette zone, les différents lasers ainsi définis étant isolés électriquement les uns des autres par des sillons (24) gravés dans la couche de contact et la couche de confinement et affleurant la couche active (14), chaque laser possédant ainsi une couche de contact en propre mais un substrat en commun avec les autres lasers, les différents lasers étant isolés optiquement les uns des autres par la zone (30) de la couche active située sous le sillon, zone qui a subi le bombardement protonique définissant chaque ruban, selon lequel:

- on réalise une première double hétérostructure sur le substrat (10) par épitaxie avec la couche active (14) ayant une première composition et la couche de contact (18),
- on décape la double première hétérostructure obtenue jusque dans le substrat, à travers un masque muni d'ouvertures en forme de bandes, ce qui conduit à un substrat sur lequel subsistent des bandes (A, A'...) de la première double hétérostructure séparées par des parties décapées,
- on fait croître dans les parties décapées une seconde double hétérostructure (B, B'...) avec la couche active (14) ayant une seconde composition et la couche de contact (18),
- on grave le sillon (24) entre la première (A) et la seconde (B) hétérostructure jusqu'à la couche active (14),
- on effectue un bombardement protonique du sillon (24).

2. Procédé selon la revendication 1, caractérisé en ce qu'on décape la première double hétérostructure à travers un masque de nitrure de silicium par une solution acide.

3. Procédé selon la revendication 1, caractérisé en ce que, pour graver le sillon (24), on grave d'abord une couche métallique supérieure (20) du contact électrique puis on utilise ce contact gravé comme masque dans une attaque chimique.

4. Procédé selon la revendication 1, caractérisé en ce qu'on décape la première double hétérostructure à travers un masque dont on place les ouvertures parallèlement à la direction <011>.

5. Procédé selon la revendication 1, caractérisé en ce que l'on effectue une attaque chimique d'au moins une des faces des doubles hétérostructurs pour obtenir l'un des miroirs des lasers, le masque étant constitué par la couche métallique de contact (20).

6. Procédé selon la revendication 1, caractérisé en ce que dans les couches de contact (18) et de confinement (16) et à proximité de l'une des extrémités de la double hétérostructure, un sillon (40) est gravé perpendiculairement aux rubans, les parties de la double hétérostructure comprises entre ce sillon et ladite extrémité constituant des diodes (42A, 42B) de détection intégrées au laser.

**Patentansprüche**

1. Verfahren zur Herstellung eines Halbleiterlasers mit mehreren Wellenlängen von der Art mit doppelter Heterostruktur und mit Band, wobei die doppelte Heterostruktur von einem Substrat (10) gebildet ist, das mit einen elektrischen Kontakt (12), einer ersten Einschließungsschicht (13) auf dem Substrat, einer die Einschließungsschicht bedeckenden aktiven Schicht (14), einer zweiten Einschließungsschicht (16), die die aktive Schicht bedeckt, und einer Kontaktschicht (18) versehen ist, die von einer alles überhöhenden metallischen Schicht (20) bedeckt ist, wobei das Band zwischen zwei seitlichen Zonen (28A, 28B) definiert wird, die eine Protonenbombardierung erfahren haben und sich über die Kontaktschicht und einen Teil der Einschließungsschicht erstrecken, wobei die aktive Schicht (14) in ihrer Ebene wenigstens zwei Zonen unterschiedlicher Zusammensetzungen aufweist, wobei jede Zone einen Laser (A, B) definiert, der mit einer Wellenlänge ($\lambda_A$, $\lambda_B$) strahlt, die durch die Zusammensetzung dieser Zone bestimmt ist, wobei die so definierten Laser elektrisch voneinander durch Rillen (24) isoliert sind, die in die Kontaktschicht und die Einschließungsschicht gegraben sind und die aktive Schicht (14) zutage treten lassen, wobei jeder Laser auf diese Weise eine eigene Kontaktschicht, jedoch ein mit den anderen Lasern gemeinsames Substrat besitzt, die verschiedenen Laser optisch voneinander durch die Zone (30) der aktiven Schicht isoliert sind, die unter der Rille liegt, welche Zone, die eine Protonenbombardierung erfahren hat, jedes Band definiert, wobei man:
- eine erste doppelte Heterostruktur auf dem Substrat (10) durch Epitaxie mit der aktiven Schicht (14), die eine erste Zusammensetzung hat, und der Kontaktschicht (18) ausbildet,
- die doppelte erste Heterostruktur, die bis in dem Substrat erhalten wurde, durch eine Maske anätzt, die mit Öffnungen in Form von Bändern versehen ist, was zu einem Substrat führt, auf welchem Bänder (A, A' ...= der ersten doppelten Heterostruktur zurückbleiben, die durch geätzte Abschnitte getrennt sind,
- in den geätzten Abschnitten eine zweite doppelte Heterostruktur (B, B' ...) mit der aktiven Schicht (14) wachsen läßt, die eine zweite Zusammensetzung und die Kontaktschicht (18) hat,
- die Rille (24) zwischen der ersten (A) und der zweiten (B) Heterostruktur bis zur aktiven Schicht (14) gräbt,
- eine Protonenbombardierung der Rille (24) ausführt.

2. Verfahren nach Anspruch 1, dadurch gekennzeichnet, daß man die erste doppelte Heterostruktur durch eine Siliciumnitridmaske mit einer sauren Lösung ätzt.

3. Verfahren nach Anspruch 1, dadurch gekennzeichnet, daß man zum Graben der Rille (24) zunächst eine obere metallische elektrische Kontaktschicht (20) gräbt und man dann diesen gegrabenen Kontakt als Maske bei einem chemischen Angriff verwendet.

4. Verfahren nach Anspruch 1, dadurch gekennzeichnet, daß man die erste doppelte heterostruktur durch eine Maske hindurch ätzt, von der man die Öffnungen parallel zur Richtung <011> ausrichtet.

5. Verfahren nach Anspruch 1, dadurch gekennzeichnet, daß man einen chemischen Angriff wenigstens einer der Flächen der doppelten Heterostrukturen ausführt, um den einen der Laserspiegel zu erhalten, wobei die Maske durch die metallische Kontaktschicht (20) gebildet ist.

6. Verfahren nach Anspruch 1, dadurch gekennzeichnet, daß in den Kontakt- und Einschließungsschichten (18, 16) und in der Nähe einer der Enden der doppelten Heterostruktur eine Rille (40) senkrecht zu den Bändern gegraben ist, wobei die zwischen dieser Rille und dem genannten Ende enthaltenen Abschnitte der doppelten Heterostruktur Detektordioden (42A, 42B) bilden, die mit dem Laser integriert sind.

**Claims**

1. Process for the production of a semiconductor laser with several wavelengths of the type having a double heterostructure and a ribbon, the double heterostructure being formed from a substrate (10) provided with an electric contact (12), a first confinement layer (13) deposited on the substrate, an active layer (14) covering the confinement layer, a second confinement layer (16) covering the active layer and a contact layer (18) covered by a metal coating (20) surmounting all of these, the ribbon being defined by two lateral zones (28a, 28b) which have undergone proton bombardment and which extend through the contact layer and part of the confinement layer, the active layer (14) having in its plane at least two zones of different compositions, each zone defining a laser (A, B) emitting a wavelength $\lambda_A$, $\lambda_B$ defined by the composition of said zones, the different lasers defined in this way being electrically isolated from one another by grooves (24) etched in the contact layer and the confinement layer and flush with the active layer (14), each laser thus having its own contact layer, but a common substrate with the other lasers, the different lasers being optically isolated from one another by the zone (30) of the active layer beneath the groove, said zone having undergone the proton bombardment defining each ribbon, according to which:

- a first double heterostructure is produced on the substrate (10) by epitaxy with an active layer (14) having a first composition and on the contact layer (18),

- the first double heterostructure obtained is etched into the substrate, through a mask having openings in the form of strips, which leads to a substrate on which there are strips (A, A'...) of the first double heterostructure separated by etched portions,

- in the etched portions is grown a second double heterostructure (B, B' ...) with its active layer (14) having a second composition and the contact layer (18),

- a groove (24) is formed between the first (A) and second (B) heterostructures down to the active layer (14), and

- the groove (24) undergoes proton bombardment.

2. Process according to claim 1, characterized in that the first double heterostructure is etched through a silicon nitride mask by means of an acid solution.

3. Process according to claim 1, characterized in that for forming the groove (24), an upper metal coating (20) of the electrical contact is firstly etched and said etched contact is used as a mask in a chemical etching process.

4. Process according to claim 1, characterized in that the first double heterostructure is etched through a mask, whose openings are placed parallel to the direction <011>.

5. Process according to claim 1, characterized in that chemical etching is carried out on at least one of the faces of the double heterostructures in order to obtain one of the mirrors of the lasers, the mask being constituted by the metal contact coating (20).

6. Process according to claim 1, characterized in that the contact (18) and confinement (16) layers and in the vicinity of one of the ends of the double heterostructure, a groove (40) formed perpendicularly to the ribbons, the portions of the double heterostructure between said groove and the said end constituting the detection diodes (42A, 42B) integrated into the laser.

EP 0 091 859 B1

# FIG.1

# FIG.2

1

# FIG.3

# FIG.4

# FIG.5